Europäisches Patentamt

European Patent Office

Office européen des brevets

(19)

(11) Veröffentlichungsnummer: **0 011 699**
**B1**

# (12) EUROPÄISCHE PATENTSCHRIFT

(45) Veröffentlichungstag der Patentschrift:
**27.04.83**

(21) Anmeldenummer: **79103896.1**

(22) Anmeldetag: **10.10.79**

(51) Int. Cl.³: **G 01 R  29/02,** H 04 L  1/00,
H 04 B  3/04, H 04 Q  1/20,
H 03 K  5/19

(54) Schaltung zur Ermittlung des Phasenjitters von Digitalsignalen und deren Verwendung.

(30) Priorität: **24.10.78  DE 2846271**

(43) Veröffentlichungstag der Anmeldung:
**11.06.80 Patentblatt 80/12**

(45) Bekanntmachung des Hinweises auf die Patenterteilung:
**27.04.83 Patentblatt 83/17**

(84) Benannte Vertragsstaaten:
**AT BE CH FR GB IT NL SE**

(56) Entgegenhaltungen:
**DE-A-2 449 341**
**DE-A-2 453 904**
**DE-A-2 709 726**
**DE-A-2 754 256**
**DE-B-2 135 308**
**DE-B-2 319 897**
**US-A-3 325 730**
**US-A-4 074 358**

(73) Patentinhaber: **SIEMENS AKTIENGESELLSCHAFT,**
**Berlin und München Wittelsbacherplatz 2,**
**D-8000 München 2 (DE)**

(72) Erfinder: **Kammerlander, Karl, Wiesenstrasse 10,**
**D-8190 Wolfratshausen (DE)**

ACTORUM AG

Schaltung zur Ermittlung des Phasenjitters von Digitalsignalen und deren Verwendung

Die Erfindung bezieht sich auf eine Schaltung zur Ermittlung des Phasenjitters eines ankommenden, wenigstens Anteile in digitaler Form aufweisenden Signals auf der Empfangsseite einer Signalübertragungsstrecke, mit einer die Flanken der digitalen Signale bzw. Signalanteile in Zeichenwechselimpulse umformenden Differenzierschaltung, mit wenigstens einem eine periodische Zeitfunktion erzeugenden Zeitfunktionsgeber und mit einer Auswerteschaltung, der die bei Auftreten der Zeichenwechselimpulse vorliegenden augenblicklichen Zeitfunktionswerte des Zeitfunktionsgebers zugeführt sind.

Eine Schaltung dieser Art ist durch die DE-C 1 285 499 für die Messung der Zeichenverzerrung von Telegrafiesignalen bekannt. Dabei wird ein Zeitfunktionsgeber zu Beginn eines Messzyklus gestartet und am Ende eines Messzyklus wieder stillgesetzt. Mit anderen Worten wird hier die Phasenjittermessung mittels eines Zeitfensters durchgeführt, durch das das empfangsseitig regenerierte digitale Signal betrachtet und die prozentuale Streuung des Nulldurchganges der Impulsflanken festgestellt wird. Auch ist diese Schaltung dafür ausgelegt, dass sie mittels einer Schalteinrichtung für die Durchführung einer Messung der Verzerrung des Gleichlaufs eines digitalen Signals umgeschaltet werden kann. Hierbei läuft der Zeitfunktionengeber frei durch, mit der Folge, dass lediglich die relative Gleichlaufverzerrung zwischen unmittelbar aufeinanderfolgenden Signalbits festgestellt werden kann. Diese Messart ist also für die Ermittlung des Phasenjitters mangels einer festen Messbezugsgrösse ungeeignet.

Insbesondere bei der Übertragung digitaler Signale mittels Funk besteht bei adaptierenden Organisationsverfahren für eine Sende-Empfangsstation, beispielsweise eine mobile Empfangsstation, ganz allgemein das Problem, die Empfangswürdigkeit dieser Signale zu unterscheiden. Sobald nämlich ein Signal über ein bestimmtes Mass hinaus gestört ist, besteht die Gefahr, dass Verfälschungen des Nachrichteninhalts auftreten. Das Mass der Störung von Signalen wird üblicherweise als Störabstand S/N ausgedrückt, der dem Energieverhältnis des Nutzsignals $P_s$ zum Störsignal $P_N$ entspricht.

$$\frac{S}{N} = 10 \cdot 1 \, g \frac{P_S}{P_N} dB \qquad (I)$$

Bei der Übertragung digitaler Signale bzw. digitaler Signalisierungen äussert sich der wirksame Störabstand im sogenannten «Phasenjitter» des Digitalsignals. Die Jittergrösse J ist dabei das Mass der mittleren prozentualen Streuung des Nulldurchganges des Digitalsignals im Basisband, bezogen auf die Länge eines Einzelbits.

Grundsätzlich besteht für die Ermittlung der Empfangswürdigkeit ankommender Signale auf einer Übertragungsstrecke, insbesondere einer Funkstrecke, die Möglichkeit, von der Feldstärkemessung Gebrauch zu machen. Die Feldstärke allein gibt jedoch kein sicheres Mass hierfür, weil auch Störungen in Form von Fremdstörern eine ausreichende Signalfeldstärke vortäuschen können, die dem eigentlich gewünschten Signal überlagert sind. Wie beispielsweise die DE-A-2 659 635 ausweist, ist es daher angebracht, die Empfangswürdigkeit eines ankommenden Signals nicht nur durch eine Feldstärkemessung, sondern auch oder ausschliesslich durch eine Phasenjittermessung zu überprüfen.

Die bereits erwähnte Phasenjittermessung mittels Zeitfenster setzt voraus, dass der empfangsseitige Regenerator mittels einer Referenzfrequenz auf die Bitrate des ankommenden Signals mit ausreichender Genauigkeit eingestellt ist. Diese Referenzfrequenz wird durch einen lokalen, mittels eines Phasenregelkreises nachziehbaren Taktoszillator herbeigeführt. Sobald die Synchronisation des Phasenregelkreises erfolgt ist, ist sowohl der Anfang als auch das Ende jedes empfangenen Signalbits am Empfangsort bekannt. Eine solche Anordnung ist beispielsweise in der DE-B-2 047 944 beschrieben. Im allgemeinen wird die Bandbreite des Phasenregelkreises so klein gewählt, dass für das vom Taktoszillator gelieferte Referenzsignal eine Störbefreiung erreicht wird, die durch die integrierende Mittelwertbildung des Phasenregelkreises Anfang und Ende der ungestörten empfangsseitigen Bits auch bei relativ niedrigen Werten von S/N definiert.

Von Nachteil ist diese Art der Phasenjittermessung des Empfangssignals, weil sie die Synchronisation des Phasenregelkreises des Regenerators unbedingt voraussetzt. Es kann also erst nach der Synchronisation mit der Messung der Qualität des empfangenen Signals begonnen werden. Nachteilig ist auch, dass bei geringer werdendem Störabstand S/N die notwendige Störbefreiung des Referenzsignals nur dadurch erhalten werden kann, dass die Bandbreite des Phasenregelkreises entsprechend verkleinert wird. Dies führt aber zu längeren Synchronisierzeiten. Damit steigt der Aufwand an Zeit bis zu Beginn der Qualitätsmessung mit geringer werdendem Geräuschabstand. Erfolgt schliesslich keine Synchronisation mehr, weil der Geräuschabstand S/N zu gering bzw. die Störung zu hoch ist, so kann erst nach einer entsprechenden Wartezeit, die der maximalen Synchronisierzeit entspricht, die Empfangsunwürdigkeit festgestellt werden.

Besonders gravierend wirken sich die genannten Nachteile bei schnellen frequenzbeweglichen und adaptiven Funksystemen aus, die entweder mit Frequenzsprungverfahren, automatischer Kanalsuche oder einer anderen Diversityeinrichtung arbeiten. Die bei solchen Funksystemen für die Adaptionsvorgänge erforderlichen Mindestzeiten werden durch die Phasenjittermessung dadurch erheblich vergrössert, dass gerade bei gestörten Radiokanälen ein grosser Zeitaufwand entsteht bis erkannt wird, dass die Verbindung ungeeignet ist.

Der Erfindung liegt die Aufgabe zugrunde, für eine Schaltung zur Ermittlung des Phasenjitters empfangsseitig ankommender digitaler Signale bzw. digitaler Signalisierungen eine Lösung anzugeben, die eine schnelle Qualitätsprüfung erlaubt, also die Synchronisation des Regenerator-Phasenregelkreises nicht vorauszusetzen braucht.

Diese Aufgabe wird ausgehend von einer Schaltung der einleitend beschriebenen Art gemäss der Erfindung durch die im Kennzeichen des Anspruchs 1 angegebenen Merkmale gelöst.

Der Erfindung liegt die wesentliche Erkenntnis zugrunde, dass sich die für eine Qualitätsbeurteilung notwendige Phasenjittermessung eines ankommenden digitalen Signals auch asynchron durchführen lässt, wenn hierfür ein von den Zeichenwechselimpulsen eines ankommenden Signals rückgesetzter, die Bitdauer der aufeinanderfolgenden Signalbits mittels einer Zeitfunktion ausmessender Zeitfunktionsgeber vorgesehen wird, sofern dieser freilaufende, eine periodische Funktion erzeugende Zeitfunktionsgeber eine ausreichende Frequenzkonstanz aufweist. Diese Voraussetzung ist, wie umfangreiche Untersuchungen ergeben haben, bei Anwendung üblicher Schaltungstechnik grundsätzlich gegeben.

Da der Zeitfunktionengeber mit jedem Zeichenwechselimpuls in eine bestimmte Ausgangsstellung rückgesetzt wird, kann seine Periode praktisch beliebig, beispielsweise grösser als eine Signalbitperiode gewählt werden. Für viele Anwendungen ist es jedoch zweckmässig, die Periodendauer des Zeitfunktionsgebers gleich der zu erwartenden Bitperiode des empfangenen Signals zu wählen.

Der Zeitfunktionsgeber kann analog oder digital ausgeführt sein. In analoger Ausführung wird er zweckmässig in Form eines Sägezahns oder eines Dreieckgenerators verwirklicht. In digitaler Ausführung ist es sinnvoll, einen von einem Zähltaktgenerator gesteuerten Zähler vorzusehen, wobei der Zähltaktgenerator eine wesentlich höhere Taktfrequenz als der Bittakt des empfangenen Signals aufweist. Vorzugsweise ist der Zähler ein Auf-Abwärtszähler.

Sinnvoll wird die Phasenjittermessung bei ankommenden digitalen Signalen bzw. digitalen Signalisierungen im Empfangszug hinter einem Basisbandbegrenzer vorgenommen.

Bei einer Weiterbildung der Erfindung weist die Differenzierschaltung zwei Ausgänge, nämlich einen Ausgang für die differenzierten aufsteigenden bzw. positiven und einen Ausgang für die differenzierten absteigenden bzw. negativen Flanken der Signalbitfolge auf. Ferner sind zwei gleiche Zeitfunktionsgeber vorgesehen, deren Rückstelleingänge mit den beiden Ausgängen der Differenzierschaltung und deren Zeitfunktionswertausgänge mit zugehörigen Eingängen der Auswerteschaltung in Verbindung stehen. Auf diese Weise lassen sich unter anderem Verfälschungen der Messergebnisse des Phasenjitters durch Schwankungen des Tastverhältnisses der ankommenden Signalbitfolge unterdrücken. Solche Tastverhältnisschwankungen stellen praktisch eine dem digitalen Signal überlagerte Gleichstromkomponente des Basissignals dar, die durch Driften von Frequenzerzeugern, durch Unsymmetrien bei Filtern, Modulatoren, Koppelgliedern und Operationsverstärkern auftritt.

Zweckmässig besteht die Auswerteschaltung aus einem dem Zeitfunktionsgeber bzw. den Zeitfunktionsgebern nachgeschalteten Addierer, einem an den Ausgang bzw. die Ausgänge der Differenzierschaltung angeschalteten Ereigniszähler und einem einen Verhältnisbildner umfassenden Auswerter, dessen einem Eingang das eine vorgegebene bestimmte Messblocklänge anzeigende Zählergebnis des Ereigniszählers und dessen anderem Eingang gleichzeitig die jeweils über eine Messblocklänge im Addierer aufaddierten Zeitfunktionswerte zugeführt sind. Im einfachsten Falle besteht der Auswerter aus einem Verhältnisbildner.

Bei Verwendung einer Differenzierschaltung mit zwei Ausgängen für die getrennte Ausgabe der Zeichenwechselimpulse aus den differenzierten positiven und negativen Flanken und zwei gleichen Zeitfunktionsgebern, mit deren Hilfe sich die eine Störgrösse für das Messergebnis darstellende überlagerte Gleichstromkomponente des ankommenden Signals in der Basisbandlage eliminieren lässt, ergibt sich in einer anderen Weiterbildung der Erfindung die Möglichkeit, dieser Gleichstromkomponente bzw. den sie verursachenden Stromflusswinkel indirekt zu messen und diese Messgrösse für Regelzwecke zu verwenden. Hierzu weist die Auswerteschaltung weiterhin einen von den an einem der beiden Ausgänge der Differenzierschaltung auftretenden Zeichenwechselimpulsen getakteten Komparator, einen dem Komparator nachgeschalteten, im Rhythmus einer Messblocklänge rückgesetzten Integrator und einen zusätzlichen Verhältnisbildner auf, dessen einer Eingang mit dem Integratorausgang in Verbindung steht und dessen anderem Eingang im Rhythmus einer Messblocklänge das halbe Zählergebnis des Ereigniszählers zugeführt ist. Hierbei steht jeder der beiden Eingänge des Komparators mit einem zusätzlichen Zeitfunktionsausgang der beiden Zeitfunktionsgeber in Verbindung. Dabei bildet der Ausgang des zusätzlichen Verhältnisbildners einen zweiten Ausgang der Auswerteschaltung für das erwähnte Stromflusswinkelsignal.

Wird eine längere Messzeit zugelassen, dann kann der Phasenjitter unabhängig vom Vorhandensein eines Stromflusswinkels auch dadurch einwandfrei gemessen werden, dass die lediglich einen Ausgang aufweisende Differenzierschaltung an diesem Ausgang nur solche Zeichenwechselimpulse abgibt, die von Signalflanken in aufsteigender oder absteigender Richtung abgeleitet sind.

Soll die Phasenjittermessung bei Funksystemen höherer Flexibilität zur automatischen Adaption an die jeweils besten Empfangsverhältnisse herangezogen werden, so ist es sinnvoll, den Auswerter aus einem Mikroprozessor mit zwei eingangsseitigen, vom Mikroprozessor angesteuerten Speichern aufzubauen. Die für die automatische Adaption des Funksystems erforderliche Logik liefert hierbei dann der Mikroprozessor.

Die Erfindung eignet sich auch in vorteilhafter Weise zur Messung des Phasenjitters kurzer Digitalkennungen von wenigen Millisekunden Dauer. Die Phasenjittermessung, die hier nur während der Kennungsblöcke aktiviert ist, geht dabei von einer Anordnung aus, die von einer Differenzierschaltung mit zwei Ausgängen und zwei Zeitfunktionsgebern Gebrauch macht. Zweckmässig besteht in diesem Fall die Auswerteschaltung aus einem Mikroprozessor mit vier eingangsseitigen von Mikroprozessor angesteuerten Speichern. Dabei stehen zwei Speicher mit ihren Eingängen mit den Zeitfunktionswertausgängen der beiden Zeitfunktionsgeber und zwei Speicher mit ihren Eingängen mit den Ausgängen der Differenzierschaltung in Verbindung. Der Mikroprozessor vergleicht die ankommenden Kennungsblöcke fortlaufend mit einem ihm eingespeicherten Kennungsmuster und überprüft gleichzeitig die Qualität des empfangenen Signals mit Hilfe der Phasenjittermessung, wodurch er ein zuverlässiges Kriterium für die maximale Anzahl der festgestellten zulässigen Fehler beim Vergleich der ankommenden Kennungsblöcke mit dem Sollmuster erhält.

Die Schaltung nach der Erfindung lässt sich auch in einer anderen Weiterbildung in ausserordentlich vorteilhafter Weise in der Synchronisiereinrichtung für den Zeittaktgeber eines Funkempfängers, bei der das Regelsignal für den in seiner Phase und/oder Frequenz steuerbaren Zeittaktgeber über einen Phasenvergleich der Taktoszillatorschwingung mit dem ankommenden Signal in einem Phasenvergleicher gewonnen ist, derart verwenden, dass im Verbindungsweg zwischen dem Ausgang des Phasenvergleichers und dem Stelleingang des Zeittaktgebers ein steuerbarer Schalter vorgesehen ist, der vom Ausgangssignal des Auswerters der Auswerteschaltung über eine Schwellwertschaltung angesteuert wird und immer dann und so lange die Regelsignalzufuhr unterbricht, wie dieses Ausgangssignal einen unzulässig hohen Phasenjitterwert anzeigt. Die auf diese Weise herbeigeführte Aussetzung der Phasennachregelung des Taktoszillators stellt eine wesentliche Verbesserung der Betriebseigenschaften eines solchen Funkempfängers dar, weil bei kurzzeitig auftretenden Störungen ein unkontrolliertes Wegdriften des Taktoszillators unterbunden wird.

Weiterhin lässt sich die Schaltung zur Messung des Signalgeräuschabstandes S/N im Übertragungskanal in einer anderen Weiterbildung (nach der Erfindung) auf einer Endstelle einer Nachrichtenübertragungsstrecke für Analogsignale derart verwenden, dass sendeseitig in den Analogsignalfluss in Zeitabständen von der Grössenordnung sec. digitale Kennungsblöcke von der Dauer weniger msec. eingeblendet sind, die zeitsynchron auf der Empfangsseite wiederum ausgeblendet und dem Eingang der Schaltung zur Messung des Phasenjitters zugeführt sind. Dabei werden die Lücken im empfangsseitigen Analogsignalfluss anschliessend durch ein analoges Echosignal, das mittels eines Schieberegisters gewonnen ist, wiederum ausgefüllt.

Anhand der in den Zeichnungen dargestellten Ausführungsbeispiele soll die Erfindung im folgenden noch näher erläutert werden.

In den Zeichnungen bedeuten:

Fig. 1 verschiedene über der Zeit aufgetragene Diagramme zur Erläuterung der Wirkungsweise der Schaltung nach der Erfindung,

Fig. 2 ein den Zusammenhang zwischen dem Phasenjitter und dem Geräuschabstand darstellendes Diagramm,

Fig. 3 weitere über der Zeit aufgetragene Spannungsdiagramme zur Erläuterung der Wirkungsweise der Schaltung nach der Erfindung,

Fig. 4 eine erste Ausführungsform einer Schaltung nach der Erfindung,

Fig. 5 eine zweite Ausführungsform einer Schaltung nach der Erfindung,

Fig. 6 eine spezielle Ausführungsform eines Auswerters in einer Schaltung nach Fig. 4 oder 5,

Fig. 7 ein empfängerseitiges Blockschaltbild mit einer Schaltung nach Fig. 4 oder 5,

Fig. 8 das Blockschaltbild einer Sende-Empfangsschaltung mit einer Schaltung nach Fig. 4 oder 5,

Fig. 9 eine weitere Schaltung nach der Erfindung.

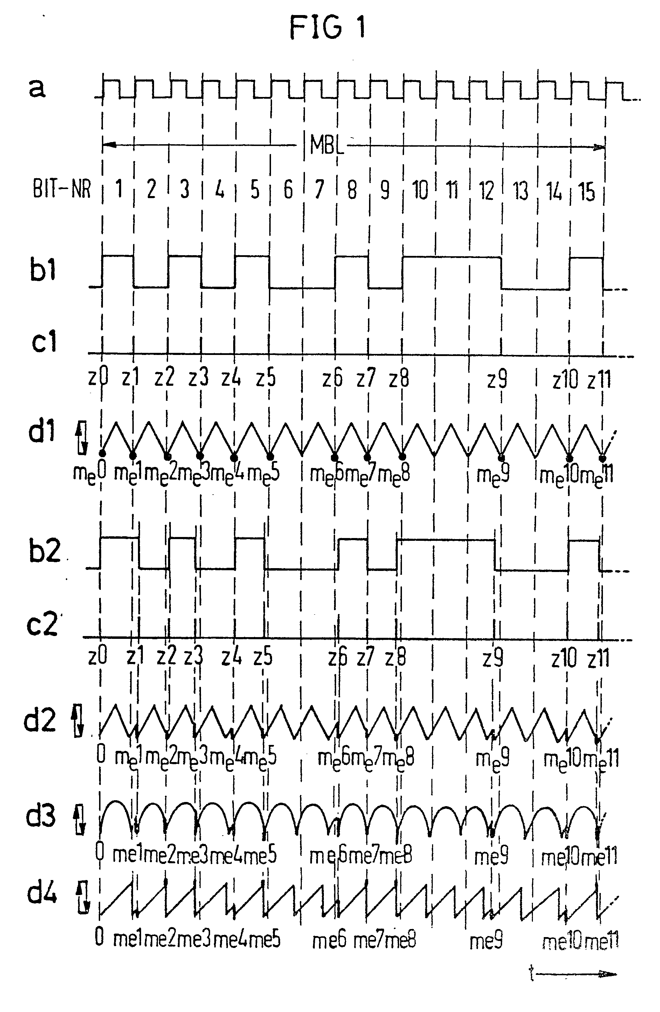

Zur Erläuterung des bei der Erfindung zur Anwendung kommenden Messverfahrens sind in Fig. 1 über der Zeit t eine Reihe von Spannungsdiagrammen aufgetragen. Das Diagramm a zeigt das von einem empfangsseitigen Oszillator erzeugte Taktsignal, das exakt die Bitperiode angibt, mit der das zu empfangende Signal von der Sendeseite her übertragen wird. Dieses Taktsignal ist in Fig. 1 für fünfzehn Bit 1, 2, ... 15 darstellt. Diese fünfzehn Bit stellen ein Messintervall, im folgenden Messblocklänge MBL genannt, dar. Unterhalb der Bit-NR ist im Diagramm b1 ein ungestörtes digitales Basisband-Empfangssignal angegeben, dessen auf- und absteigende Flanken exakt mit den positiven Flanken des Taktsignals nach dem Diagramm a übereinstimmen. Das Diagramm C1 gibt die Zeichenwechselimpulse $z_0$, $z_1$ ... $z_{11}$ an, die aus dem Empfangssignal b1 durch Differenzierung der Signalflanken abgeleitet sind. Das Diagramm d1 stellt die Zeitfunktion eines Zeitfunktionsgebers dar, und zwar die Zählfunktion eines Auf-Ab-Zählers, der mit einer Zählfrequenz $f_z$ angesteuert wird, die um den Faktor $2^7$ mal höher ist als die Bittaktfrequenz $f_b$ des Taktsignals. Der Zähler ist so konfiguriert, dass er von Null ausgehend 64 Zählschritte nach oben und dann anschliessend wieder nach unten zählt und auf diese Weise genau nach einem Bit wiederum in seiner Ausgangsstellung ankommt. Der Zähler hat einen Rücksetzeingang, an dem die Zeichenwechselimpulse nach Diagramm c1 anstehen. Mittels der Zählfunktion wird also mit anderen Worten die Bitzeit ausgezählt und das hierdurch erhaltene Messergebnis in Form der Messwerte me1, me2 ... me11 über eine Messblocklänge MBL hinweg einer noch näher zu beschreibenden Auswerteschaltung zugeführt. Im Diagramm d1 sind diese Messwerte, die durch schwarze Punkte markiert sind, jeweils Null, da das ankommende digitale Signal nach dem Diagramm b1 ungestört ist.

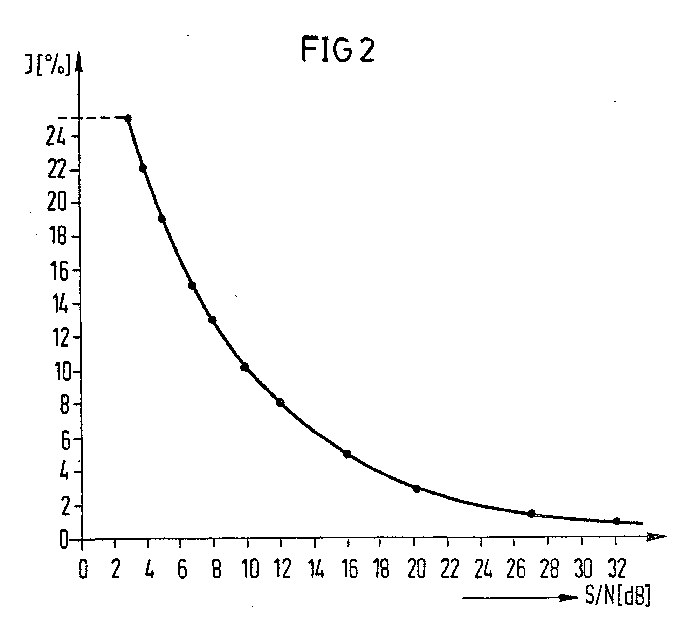

Dieses Ergebnis ändert sich, wenn das digitale Empfangssignal entsprechend Diagramm b2 einen Phasenjitter aufweist, also die Signalflanken nicht mehr exakt mit den positiven Flanken des Taktsignals nach Diagramm a übereinstimmen. In dem Diagramm c2 sind wiederum die Zeichenwechselimpulse z0, z1 ... z11 aufgetragen, deren Lage nunmehr gegenüber den Zeichenwechselimpulsen nach Diagramm c1 verschoben sind. Die Zeitfunktion des Zeitfunktionsgebers nach Diagramm d2 stimmt nunmehr in ihren Nulldurchgängen nicht mehr mit den Zeichenwechselimpulsen überein; diese stellen bei ihrem Auftreten den Auf-Ab-Zähler jeweils in seine Nullstellung zurück. Vor der Rückstellung wird das Messergebnis, das hier im augenblicklichen Zählerstand besteht, an die Auswerteschaltung weitergegeben. Die Messergebnisse me1, me2... me11 sind nun also nicht mehr Null und ergeben somit am Ausgang der Auswerteschaltung ein die Grösse des Jitters anzeigendes Signal. In den Diagrammen d3 und d4, die dem Diagramm d2 entsprechen, sind die Zeitfunktionen von Zeitfunktionsgebern dargestellt, die analog arbeiten. Die Zeitfunktion nach Diagramm d3 ist ebenfalls eine innerhalb einer Periode anwachsende und wiederum abnehmende Grösse, die einen nichtlinearen Verlauf hat und so gestaltet ist, dass sie den nichtlinearen Verlauf des Zusammenhangs zwischen dem in Fig. 2 über dem Signalgeräuschabstand S/N in dB aufgetragenen Jitter J in % und diesem Signalgeräuschabstand kompensiert. Auf diese einfache Weise ist es möglich, dass die von der Auswerteschaltung gelieferte Grösse dem Signalgeräuschabstand proportional ist und insofern eine lineare Anzeige des Signalgeräuschabstandes ermöglicht. Das Diagramm d4 zeigt den Zeitfunktionsverlauf eines Zeitfunktionsgebers an, der ein Sägezahngenerator ist und dessen Sägeperiode wiederum mit einer Bittaktperiode übereinstimmt. Je nachdem, ob die Messergebnisse me1, me2 ... me 11 im unteren oder im oberen Spannungsbereich des Sägezahnverlaufs ermittelt werden, wird auf diese Weise unmittelbar Aufschluss über die Richtung der augenblicklichen Phasenverschiebung der Nulldurchgänge des digitalen Empfangssignals erhalten. Grundsätzlich sind auch andere Zeitfunktionen denkbar. Beispielsweise könnte sich auch eine Zählfunktionsperiode über zwei Bitperioden erstrecken. Diesem Sachverhalt kommt dann Bedeutung zu, wenn für die Ableitung der Zeichenwechselimpulse lediglich Signalflanken einer Polarität benutzt werden.

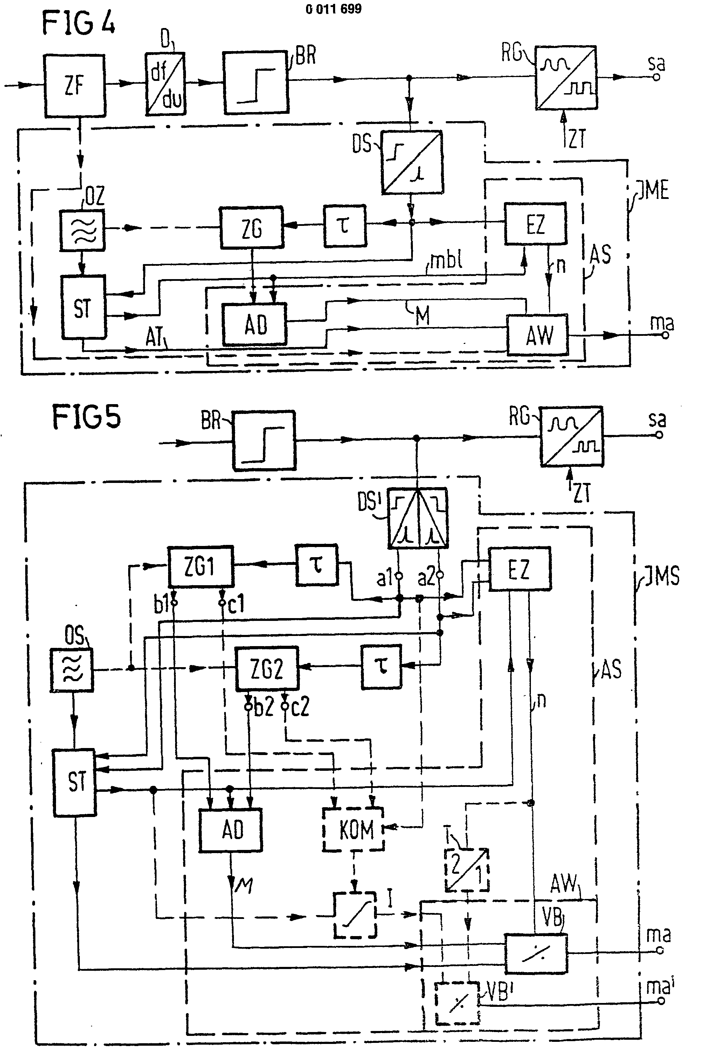

Das in Fig. 4 dargestellte Ausführungsbeispiel für eine Schaltung zur Phasenjittermessung zeigt einen Teil des empfangsseitigen Signalweges eines FM-Funkempfängers mit einem Zwischenfrequenzteil ZF auf der linken Seite, an das sich der Demodulator D anschliesst, in dem das empfangene digitale Signal von der Zwischenfrequenzlage in die Basisbandlage umgesetzt wird. Dem Demodulator D folgt der Basisbandbegrenzer BR, der ausgangsseitig mit dem Eingang des Regenerators RG verbunden ist. Für die im Regenerator RG durchzuführende Zeichenregeneration wird der Zeichentakt ZT benötigt, den ein nicht näher dargestellter Taktgenerator liefert, der mittels eines Phasenregelkreises mit der ankommenden Signalfolge in Synchronismus gebracht wird. Auf der Ausgangsseite des Regenerators RG kann das regenerierte digitale Signal in der Basisbandlage am Ausgang sa für seine weitere Verarbeitung abgenommen werden. Die eigentliche Jittermesseinrichtung JME besteht eingangsseitig aus der Differenzierschaltung DS, die mit ihrem Eingang an den Ausgang des Basisbandbegrenzers BR angeschaltet ist. Weiterhin weist die Jittermesseinrichtung den Zeitfunktionsgeber ZG, den Ereigniszähler EZ, den Addierer AD, den Auswerter AW und eine Steuereinrichtung ST auf, die mit einem frei laufenden Oszillator OZ ausreichender Frequenzkonstanz in Verbindung steht. Die Differenzierschaltung DS liefert an ihrem Ausgang die bereits erwähnten Zeichenwechselimpulse, die dem Eingang des Ereigniszählers, der Steuereinrichtung ST und über das Verzögerungsglied $\tau$ dem Rückstelleingang des Zeitfunktionsgebers ZG zugeführt werden. Ist der Zeitfunktionsgeber ZG ein Auf-Ab-Zähler, wie er im Zusammenhang mit Fig. 1 in den Diagrammen d1 und d2 beschrieben worden ist, dann ist sein Zähleingang mit einem Ausgang des Oszillators OZ verbunden, der hierbei die Schwingung mit der Zählfrequenz fz liefert. Der Zeitfunktionswertausgang des Zeitfunktionsgebers ZG ist mit dem Addierer AD verbunden, in dem die anfallenden Messwerte me1, me2 ... me11 nach Fig. 1 über eine Messblocklänge MBL aufaddiert werden. Das die Messblocklänge beinhaltende Steuersignal wird von der Steuereinrichtung ST dem Addierer AD und dem Ereigniszähler EZ zugeführt. Am Ende einer Messblocklänge gibt der Addierer das Summenmessergebnis M und der Ereigniszähler EZ das Zählergebnis n hinsichtlich der Zeichenwechselimpulse an den eigentlichen Auswerter AW ab, an dessen Ausgang ma die dem Jitter J bzw. dem Signalgeräuschabstand proportionale Grösse zur weiteren Verarbeitung bzw. zur Anzeige ansteht. Im einfachsten Fall besteht der Auswerter AW aus einem Verhältnisbildner, der das Verhältnis aus der Summe M der Messwerte me zur Ereigniszahl n und damit den Jitterwert J bildet. Wie bereits einleitend erwähnt worden ist, wird für die Qualitätsprüfung neben der Jittermessung auch mitunter eine Feldstärkemessung vorgenommen. Beide Messgrössen lassen sich in vorteilhafter Weise zu einem Qualitätskriterium A in der Weise vereinigen, dass A als das Verhältnis aus dem Eingangspegel Pe und dem Jitter J definiert wird. Dieser Sachverhalt ist in Fig. 4 durch die unterbrochene, vom ZF-Teil ausgehende Leitung zum Auswerter AW angedeutet. Der Auswerter AW, der zusammen mit dem Addierer AD und dem Ereigniszähler EZ die Auserteschaltung AS bildet, besteht in diesem Fall aus zwei Verhältnisbildern, von denen der erste Verhältnisbildner den Jitterwert abgibt und der zweite Verhältnisbildner das erwähnte Auswahlkriterium A.

Die anhand von Fig. 1 beschriebene Jittermessfunktion für die in Fig. 4 ein erstes Ausführungsbeispiel angegeben ist, geht davon aus, dass bei ungestörten Signalen und bei begrenzten digitalen Zeichenfolgen exakt gleiche Zeichenlängen (gleiche Stromflusswinkel) für die logischen Zustände «O» und «L» herrschen. Von dieser Voraussetzung kann in der Praxis nicht immer ausgegangen werden, da unvermeidliche Driften von Frequenzerzeugern, Unsymmetrien von Filtern, Demodulatoren, Kopplergliedern und Operationsverstärkern zwangsläufig zu einer dem digitalen Signal in der Basisbandlage überlagerten Gleichstromkomponente führen. Die Gleichstromkomponente stellt eine Störgrösse dar, deren Betrag von der absoluten Grösse der Gleichstromkomponente abhängt. Die Phasenjittermessung wird durch diese Störgrösse verfälscht, weil z.B. alle logischen Zustände «O» zeitlich länger sind als die logischen Zustände «L».

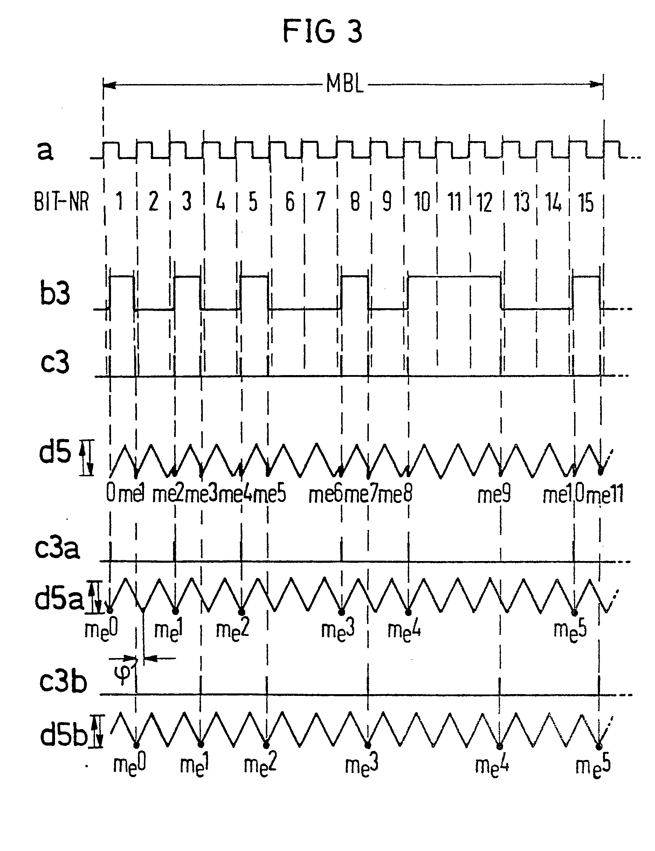

Dieser Sachverhalt ist in den Diagrammen der Fig. 3, die denen der Fig. 1 entsprechen, verdeutlicht. Das im Diagramm b3 dargestellte Signal in der Basisbandlage ist ungestört, weist jedoch eine überlagerte Gleichstromkomponente auf, die sich in einem ungleichen Tastverhältnis auswirkt. Die Zeichenwechselimpulse nach Diagramm c3 stimmen somit nicht mit den positiven Flanken der Bitfolge nach Diagramm a überein und ergeben dadurch am Ausgang des Zeitfunktionsgebers entsprechend dem Diagramm d5 vom Wert Null verschiedene Messwerte me1, me2 ... me11.

Um diese Störgrösse zu eliminieren, ist es lediglich erforderlich, für die Gewinnung der Messwerte nur solche Zeichenwechselimpulse zu verwenden, die entweder von den positiven oder den negativen Signalimpulsflanken abgeleitet sind. In Fig. 3 sind in Diagramm c3a und c3b die von den positiven bzw. von den negativen Signalimpulsflanken abgeleiteten Zeichenwechselimpulse angegeben. Die zugehörigen Diagramme für die Zeitfunktionen zeigen die Diagramme d5a und d5b. Der Einfluss des Stromflusswinkels ist nunmehr im Hinblick auf die Messergebnisse eliminiert. In den Diagrammen d5a und d5b sind die Messwerte me1, me2 ... me5 entsprechend einem ungestörten Signal jeweils Null. Allerdings wird durch diese Massnahme die Zahl der Messergebnisse über die Messblocklänge MBL halbiert. Um zu vergleichbar guten Ergebnissen im Hinblick auf die Mittelung mehrerer Messwerte zu kommen, ist es somit erforderlich, bei Anwendung von Zeichenwechselimpulsen, die entweder nur von den positiven oder nur von den negativen Signalimpulsflanken abgeleitet sind, die Messblocklänge zu verdoppeln. Diese Verdoppelung kann jedoch vermieden werden, wenn, wie das die Diagramme c3a/d5a und c3b/d5b verdeutlichen, die von den Zeichenwechselimpulsen nach dem Diagramm c3a und dem Diagramm c3b gewonnenen Messwerte auf getrennten Wegen gleichzeitig ermittelt und miteinander zu einem Summenmesswert addiert werden.

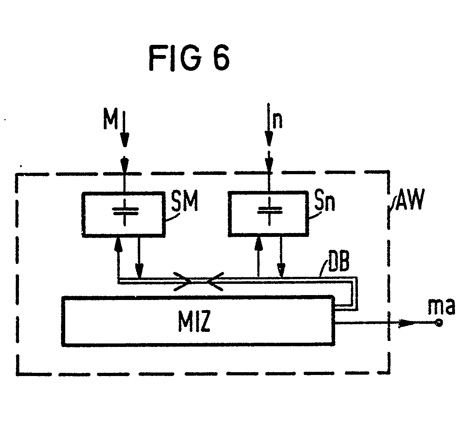

Eine entsprechende Schaltungsausführung zeigt Fig. 5. Die Differenzierschaltung DS' weist hier zwei Ausgänge a1 und a2 auf. Am Ausgang a1 stehen die Zeichenwechselimpulse an, die von den positiven Signalimpulsflanken abgeleitet sind und/am Ausgang a2 die Zeichenwechselimpulse, die von den negativen Signalimpulsflanken abgeleitet sind. Dem Ereigniszähler EZ werden beide Zeichenwechselimpulsfolgen zur gemeinsamen Zählung zugeführt. Dagegen sind nunmehr zwei Zeitfunktionsgeber ZG1 und ZG2 vorhanden, deren Steuereingänge über das Verzögerungsglied $\tau$ jeweils mit einem der beiden Eingänge a1 und a2 der Differenzierschaltung verbunden sind. Die Zeitfunktionswertausgänge b1 und b2 dieser beiden Zeitfunktionsgeber sind entsprechend Fig. 4 mit dem Addierer AD der Auswerteschaltung AS verbunden und werden dort ebenfalls über die Zeit einer Messblocklänge miteinander addiert und anschliessend dem einen Verhältnisbildner VB darstellenden Auswerter AW zugeführt, der ebenfalls das Zählergebnis n des Ereigniszählers erhält.

In Weiterbildung der Erfindung lässt sich die Schaltung nach Fig. 5 zu einer Stromwinkelmesseinrichtung erweitern, die in Fig. 5 in unterbrochenen Linien dargestellt ist. Hierzu weist die Auswerteschaltung AS einen Komparator KOM auf, der mittels der Zeichenwechselimpulse am Ausgang a1 der Differenzierschaltung DS' getaktet ist und dessen beiden Eingänge mit zusätzlichen Ausgängen c1 und c2 der Zeitfunktionsgeber ZG1 und ZG2 verbunden sind. An den Ausgängen c1 und c2 stehen die Zeitfunktionen der beiden Zeitfunktionsgeber an. Der Komparator vergleicht die beiden Zeitfunktionen miteinander und liefert das Differenzergebnis im Zeitpunkt des Auftretens eines Zeichenwechselimpulses am Ausgang a1 der Differenzierschaltung DS' an den im Rhythmus der Messblocklänge rückgestellten Integrator I, der ausgangsseitig mit dem einen Eingang eines weiteren Verhältnisbildners VB' verbunden ist. Am zweiten Eingang dieses Verhältnisbildners wird das Zählergebnis n des Ereigniszählers über einen Teiler T 2:1 zugeführt. Die ausgangsseitige Grösse dieses weiteren Verhältnisbildners kann am zweiten Ausgang ma' der Auswerteschaltung AS abgenommen werden und gibt den Stromflusswinkel nach Grösse und Vorzeichen an. Mit dieser Ausgangsgrösse kann eine empfängerinterne Entzerrerschaltung für den Stromflusswinkel angesteuert werden.

Soll der Wert des Phasenjitters bei Funksystemen höherer Organisationsflexibilität zur automatischen Adaption an die jeweils besten Empfangsverhältnisse herangezogen werden, so lässt sich der Auswerter AW nicht in der einfachen Weise gestalten, wie das bei den Ausführungsformen nach den Fig. 4 und 5 der Fall ist. Der Auswerter muss hier vielmehr durch eine Logik erweitert werden, die zweckmässig durch einen Mikroprozessor verwirklicht wird. Eine entsprechende Schaltung zeigt Fig. 6. Der Mikroprozessor MIZ ist dabei über den Datenbus DB mit zwei Speichern SM, Sn verbunden, von denen dem Speicher SM eingangsseitig die Summenwerte M des Addierers und dem Speicher Sn die Zählergebnisse n des Ereigniszählers zugeführt werden. Die Speicher SM und Sn dienen hier als Zwischenspeicher, über die die in sie eingelesenen Werte über den Datenbus mittels Adressen in den Mikroprozessor gelangen. Die Quotientenbildung erfolgt dann erst im Mikroprozessor.

Ein allgemeines Problem beim Mobilfunk besteht darin, dass aufgrund der ortsabhängigen Verteilung der Empfangsenergie und unter Einfluss von topografischen Gegebenheiten Funkschatten entstehen. Befindet sich eine Mobilstation in einem solchen Funkschatten, so empfängt sie in der Regel nur noch Rauschen, was dazu führt, dass der Regenerator, der zunächst auf die Phasenlage des Empfangssignals nachgeführt war, undefiniert wegdriftet. Sobald nun wieder Funkkontakt besteht, muss der Regenerator erneut synchronisieren, wodurch Zeit verlorengeht. Dies ist besonders bei modernen, schnell frequenzbeweglichen Systemen von erheblichem Nachteil. Dieser Nachteil lässt sich beseitigen, wenn gemäss einer Weiterbildung der Erfindung die Jittermesseinrichtung in der Synchronisiereinrichtung zur Steuerung der Funktion des Phasenregelkreises für den Taktoszillator in geeigneter Weise verwendet wird.

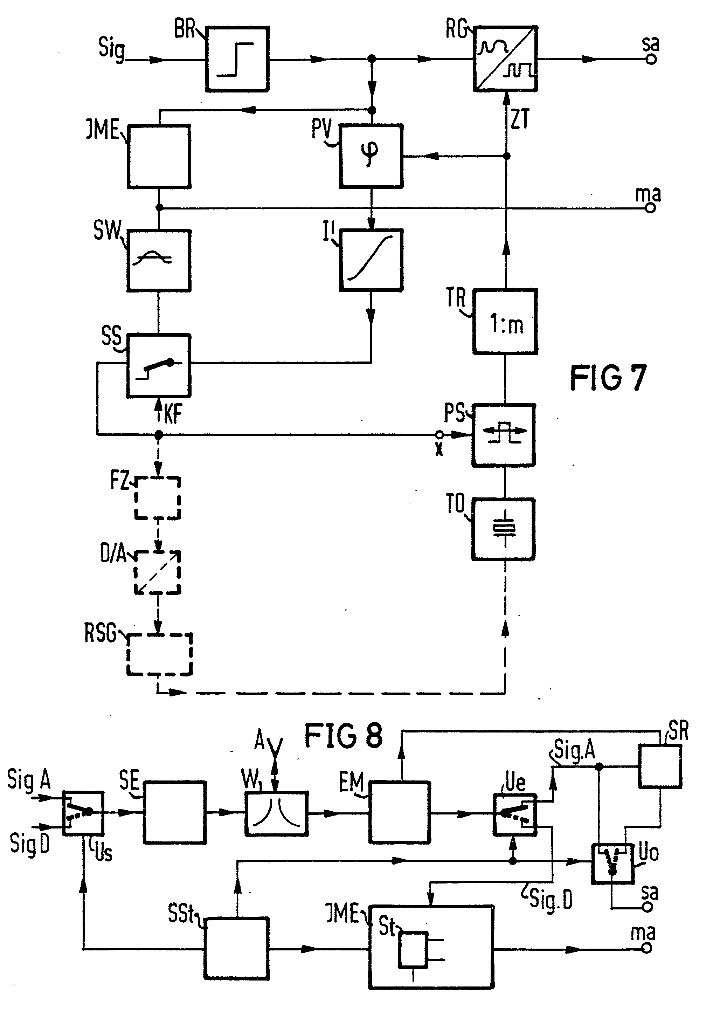

Ein entsprechendes Ausführungsbeispiel zeigt Fig. 7. Der Zeittakt ZT für den Regenerator RG wird hier dem Taktoszillator TO mit nachgeschaltetem Phasenschieber und anschliessendem Frequenzteiler TR mit dem Teilungsverhältnis 1:m entnommen. Zur Synchronisation dieses Zeittaktgebers ist ein Phasenregelkreis vorgesehen. Dieser Phasenregelkreis weist den Phasenvergleicher PV auf, dessen beiden Eingängen das ankommende digitale Signal vom Ausgang des Basisbandbegrenzers BR sowie der Zeittakt am Eingang des Regenerators zugeführt wird. Der Phasenvergleicher PV ist ausgangsseitig mit dem Integrator I′ verbunden, der das eigentliche Regelsignal erzeugt und bei bekannten Schaltungen mit seinem Ausgang unmittelbar mit dem Stelleingang x des Phasenschiebers PS verbunden ist. Gemäss einer Verwendungsmöglichkeit der Erfindung ist nun im Verbindungsweg zwischen dem Ausgang des Integrators I′ und dem Stelleingang x der steuerbare Schalter SS angeordnet, dessen Steuereingang über die Schwellwertschaltung SW mit dem Ausgang der Jittermesseinrichtung JME nach den Fig. 4 oder 5 verbunden ist. Die Schwellwertschaltung SW ist so bemessen, dass über sie der Schalter SS geöffnet und damit die Zufuhr von Steuersignalen an den Setzeingang x des Phasenschiebers PS unterbrochen wird, wenn die den Phasenjitter anzeigende Ausgangsgrösse der Jittermesseinrichtung JME einen Wert überschreitet, der einen totalen oder hochprozentigen Signalverlust anzeigt. Ein undefiniertes Abdriften des Zeittaktgebers im Zeitintervall dieser Störphase wird also auf diese Weise unterbunden, so dass in der Regel nach Beendigung dieser Störphase eine Neusynchronisation des Zeittaktgebers nicht erforderlich ist. Der Schalter SS hat zusätzlich noch einen weiteren Steuereingang über den durch ein Korrekturfreigabesignal KF die Regelung unterbrochen werden kann, wenn dies aus Gründen einer organisationsabhängigen Steuerung wünschenswert ist.

Ein weiterer Gewinn zur Verbesserung der Regenerationseigenschaften wird dadurch erzielt, dass ausser der Phase des Zeittaktes ZT für den Regenerator auch dessen Taktfrequenz exakt auf die Taktfrequenz des empfangsseitigen digitalen Signals nachgeführt wird. In Fig. 7 ist in unterbrochener Linie diese Frequenznachregelung eingezeichnet. Sie besteht eingangsseitig aus einem auf Seiten des Stelleingangs x an die Regelschleife angeschlossenen Fehlerzählers FZ, an den sich ein Digital-Analog-Wandler D/A anschliesst. Der Ausgang des Digital-Analog-Wandlers ist über den Regelsignalgeber RSG mit dem Steuereingang des Taktoszillators TO verbunden. Die durch die Jittermesseinrichtung JME über den Schalter SS freigegebenen Stellimpulse für den Phasenschieber PS, die entweder ein positives oder negatives Vorzeichen besitzen, werden dem Fehlerzähler FZ zugeführt, der bei Übereinstimmung der Frequenzen zwischen dem Zeittakt und dem empfangenen Signal eine mittlere Zählstellung einnimmt. Bei Frequenzabweichung verlässt der Fehlerzähler diese mittlere Zählstellung und aktiviert über den Digital-Analog-Wandler D/A den Regelsignalgeber RSG, der seinerseits in kleinen Schritten die Frequenz des Taktoszillators im gewünschten Sinne verstellt. Auch hier wird mit Hilfe des von der Jittermesseinrichtung JME gesteuerten Schalters SS verhindert, dass bei Signaleinbrüchen der Oszillator in seiner Frequenz in undefinierter Weise wegdriftet.

Soll bei automatischen mobilen oder festen Funkeinrichtungen eine Verbindung aufgebaut werden, so findet einleitend ein digitaler Zeichenaustausch statt, der der gegenseitigen Identifizierung dient. Dieser Zeichenaustausch ist sowohl bei volldigitalen wie auch bei analogen Verbindungen notwendig. Mit der erfindungsgemässen Schaltung zur asynchronen Phasenjittermessung ist es möglich, die hiermit ermöglichte Qualitätsprüfung bereits während der Aufbauphase einer Verbindung zu benutzen, um auf diese Weise sehr schnell zu erkennen, ob die Verbindung für den jeweilig beabsichtigten Zweck geeignet oder ungeeignet ist. Bei festgestellter mangelnder Eignung kann mittels des Qualitätskriteriums das sofortige Auflösen der Verbindung veranlasst werden. Ein automatisch adaptierendes Kanalsuchverfahren wird in diesem Fall sofort den Verbindungsaufbau auf einem anderen Kanal beginnen.

Auch die automatische Überwachung von Verbindungen während des Nachrichtenaustausches ist mit der Schaltung zur Phasenjittermessung nach der Erfindung möglich, weil bei dieser Art der Jittermessung ständig der aktuelle Wert des Signalgeräuschabstandes unabhängig vom Empfangspegel zur Verfügung gestellt werden kann.

Schwieriger ist diese Situation, wenn, wie z. B. beim öffentlich beweglichen Landfunk, der Nachrichtenaustausch analog erfolgt. Bisher gibt es keine Möglichkeit für den Analogkanal, den Signalgeräuschabstand während des Gesprächs zu messen. Dies ist insofern von grossem Nachteil, weil beim öffentlich beweglichen Landfunk von der Qualitätsprüfung der Strecke zwangsläufig die Gebührenzählung abhängig gemacht werden muss. Da für diese Qualitätsprüfung aber lediglich das Empfangspegelkriterium zur Verfügung steht, läuft immer dann, wenn dem eigentlichen Signal eine starke Störung überlagert wird, die Gebührenzählung trotz des möglichen Zusammenbruchs der Strecke weiter.

Die Schaltung zur Phasenjittermessung kann in Weiterbildung der Erfindung auch bei analoger Signalübertragung dadurch zur Anwendung kommen, dass in das klare oder auch verschleierte Analogsignal eine kurze Digitalkennung von wenigen Millisekunden Dauer in grösseren Zeitabständen (ca. 1 sec) in den Signalfluss eingefügt wird, die der gegenseitigen Identifizierung dient. Wird nunmehr die Nutzverbindung gestört, so fällt bei starker Störung die Kennung völlig aus und unterbricht die Verbindung. Erreicht die Störung nur ein gewisses Mass, das noch nicht zum Ausfall der Kennung führt, aber trotzdem die Verständlichkeit schon zu stark beeinträchtigt, so kann dies durch die erfindungsgemässe Messung des Phasenjitters der Kennungsblöcke festgestellt und im Bedarfsfall nach entsprechender Integrationszeit die Verbindung aufgelöst werden. Die Phasenjittermesseinrichtung wird hierzu nur während der Kennungsblöcke aktiviert. Zweckmässig erfolgt das Einblenden der Kennungsblöcke in die analoge Sprache periodisch etwa im Abstand einer Sekunde, wodurch keine merkliche Störung der Sprachverständlichkeit eintritt. Die Kennungsblöcke werden empfangsseitig aus dem NF-Signal wieder ausgeblendet und die kurzen Lücken im einfachsten Fall durch eine Echoeinblendung wieder geschlossen.

Ein entsprechendes Ausführungsbeispiel für eine solche Sendeempfangsstation zeigt Fig. 8 in einer Grobdarstellung. Die Sendeempfangsstation weist einen Sender SE und einen Empfänger EM auf, die miteinander über die Weiche W mit der Antenne A verbunden sind. Auf der Modulationsseite des Senders und auf der NF-Seite des Empfängers ist jeweils ein Umschalter US und Ue angeordnet, die von einer gemeinsamen Steuereinrichtung SSt in gewissen Zeitabständen periodisch betätigt werden. Den Umschaltkontakten des sendeseitigen Umschalters Us sind das analoge Signal Sig A und das digitale Signal Sig D zugeführt. Im Rhythmus einer Sekunde wird der Umschalter Us für jeweils einige Millisekunden in die in unterbrochener Linie angegebene Schaltstellung gebracht und auf diese Weise ein digitaler Kennungsblock in den analogen Signalfluss eingeblendet. Auf der Empfangsseite wird mittels des Umschalters Ue das Digitalsignal Sig D auf die gleiche Weise wieder aus dem analogen Signalfluss ausgeblendet und der Jittermesseinrichtung JME zugeführt. Ein dritter Umschalter Uo, dessen Schaltkontakt den Signalausgang sa bildet, kann diesen Signalausgang wahlweise an den Eingang oder an den Ausgang des Schieberegisters SR anschalten, über das das Analogsignal Sig A im Anschluss an den Umschalter Ue geführt wird. Mittels dieses Umschalters Uo, der in gleicher Weise wie der Umschalter Ue von der Steuereinrichtung SSt gesteuert wird, wird im Zeitbereich der Ausblendung des digitalen Signals Sig D der im Schieberegister SR gespeicherte vorausgehende Analogsignalteil noch einmal an den Ausgang sa geführt und auf diese Weise die Signallücke geschlossen.

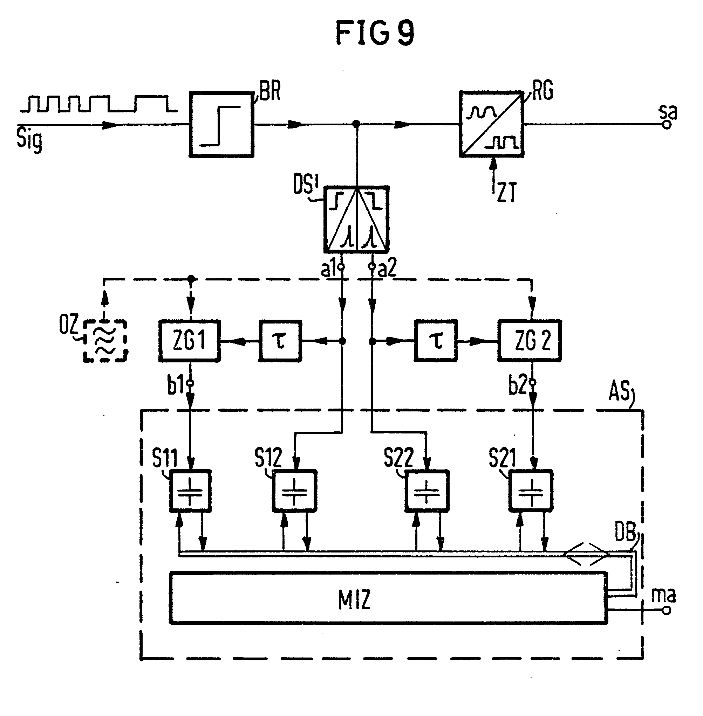

Zum Erkennen von digitalen Signalisierungscodes, z.B. Anfangssignalisierung, ist es notwendig, die Zeichenaussage mittels der Phasenjittermessung von Zeichenwechsel zu Zeichenwechsel sowohl jittermässig als auch in der gegenseitigen zeitlichen Relation und Polarität auszuwerten. Eine derartige Auswertung wird zweckmässig in Verbindung mit einem Mikroprozessor durchgeführt. Ein entsprechendes Ausführungsbeispiel zeigt Fig. 9. Die Schaltung macht hier von einer Differenzierschaltung DS′ entsprechend Fig. 5 Gebrauch und steuert über ihre beiden Ausgänge a1 und a2 jeweils einen Steuereingang eines der beiden Zeitfunktionsgeber ZG1 und ZG2. Der Ereigniszähler ist hier nicht dargestellt, da die Jittermessung nur von Zeichenwechsel zu Zeichenwechsel bewertet wird. Die Auswerteschaltung AS zeigt den Mikroprozessor MIZ, der über den Datenbus DB mit vier Speichern S11, S12, S22 und S21 in Verbindung steht. Die Speicher S11 und S21 dienen dabei als Zwischenspeicher für die Zeitfunktionswerte, an den Ausgängen b1 und b2 der Zeitfunktionsgeber ZG1 und ZG2, während in die Speicher S12 und S22 die Zeichenwechselimpulse an den Ausgängen a1 und a2 der Differenzierschaltung DS′ eingelesen werden. Damit stehen in diesen Speichern dem Mikroprozessor der Jitterwert bei jedem Zeichenwechsel zusammen mit der Polarität des Zeichenwechsels für ihre Abrufung über den Datenbus zur Verfügung. Der Mikroprozessor MIZ vergleicht fortlaufend diese Werte mit einem in ihm abgespeicherten Erwartungsmuster. Stimmen dabei die gemessenen Werte mit dem Erwartungsmuster hinsichtlich der zeitlichen Toleranz der Einzelereignisse und der Zeichenfolge, z.B. ein Vorlauf mit anschliessendem Barkercode, wie das in Fig. 9 angedeutet ist, überein, so kann diese Anordnung direkt zum Zeitzeichenempfang eingesetzt werden.

Der grosse Vorteil dieser Anordnung besteht darin, dass ein so gestalteter Zeitzeichenempfang automatisch den jeweils aktuellen Signalgeräuschabstand mitbewertet. Messungen, die zwar das Muster geben, aber aus der Sicht der Einzelmessungen wie auch der Summenmessung einen zu hohen Jitterwert aufzeigen, werden ausgeschlossen.

Der Messfehler, der bei der Jittermessung nach der Erfindung dadurch auftritt, dass der Zeitfunktionsgeber frei läuft, also asynchron zur ankommenden digitalen Signalfolge ist, kann im allgemeinen praktisch vernachlässigt werden.

Wird beispielsweise ein durch einen Auf-Ab-Zähler realisierter Zeitfunktionsgeber angenommen, der von einem freilaufenden Oszillator mit einer Genauigkeit von $1 \cdot 10^{-3}$ auf die Sollfrequenz von $2^7$ der Bitfrequenz des ankommenden Signals abgestimmt ist, so ergibt sich bei störungsfreiem Signal entsprechend dem Diagramm b1 nach Fig. 1 ein Auf-Ab-Zählfehler von 0,1%, bezogen auf jedes Einzelbit. Dieser Fehler würde im Endergebnis der Jittermessung einen besterreichbaren Signalgeräuschabstand bei einem fortlaufenden Mäander von deutlich grösser als 40 dB darstellen. Dies bedeutet eine immer noch hohe Übertragungsqualität. Bedingt durch die Eigenart der Messung nach der jede Einzelmessung wieder mit Null beginnt, wird sichergestellt, dass der jeweils aufgelaufene Fehler sich nicht von Messung zu Messung aufaddiert. Dieser Fehler kann in der Praxis auf ca. 1% ansteigen, da in einem pseudostatistischen Text naturgemäss auch längere Bänke gleichgepolter Signale auftreten, bei denen der Auf-Ab-Zähler ohne zwischenzeitliche Rückstellung den Frequenzfehler aufaddiert und dann je nach Länge der Bank eine Fehlervergrösserung eintritt.

Völlig vernachlässigbar wird das Problem jedoch dann, wenn davon ausgegangen wird, dass in modernen Funkgeräten Quarzgeneratoren mit einer Genauigkeit von $1 \cdot 10^{-5}$ zur Verfügung stehen. Bei einer Bank von tausend gleichsinnigen Bits wird dann ein durch Asynchronität verursachter Einzelfehler von 1% entstehen, der wegen der Seltenheit des Ereignisses bei der Mittelwertbildung völlig untergeht und überdies vom gerätebedingten Jitter weit überdeckt wird.

**Patentansprüche**

1. Schaltung zur Ermittlung des Phasenjitters eines ankommenden, wenigstens Anteile in digitaler Form aufweisenden Signals auf der Empfangsseite einer Signalübertragungsstrecke, mit einer die Flanken der digitalen Signale bzw. Signalanteile in Zeichenwechselimpulse umformenden Differenzierschaltung (DS DS'), mit wenigstens einem eine periodische Zeitfunktion erzeugenden Zeitfunktionsgeber (ZG, ZG1, ZG2) und mit einer Auswerteschaltung (AS), der die bei Auftreten der Zeichenwechselimpulse vorliegenden augenblicklichen Zeitfunktionswerte des Zeitfunktionsgebers zugeführt sind, dadurch gekennzeichnet, dass der freilaufend ausgeführte Zeitfunktionsgeber (ZG, ZG1, ZG2) jeweils durch die Zeichenwechselimpulse in eine vorgegebene Ausgangsstellung rückgesetzt wird und dass die Auswerteschaltung (AS) eine Einrichtung (AD, EW, AW; AD, EZ, VB; SM, Sn, MIZ; $S_{11}$, $S_{12}$, $S_{12}$, $S_{22}$, Miz) zur Bildung des Mittelwerts der in einem vorgegebenen Messzeitintervall empfangenen augenblicklichen Zeitfunktionswerte enthält.

2. Schaltung nach Anspruch 1, dadurch gekennzeichnet, dass die Periodendauer des Zeitfunktionsgebers (ZG) gleich der zu erwartenden Bitperiode des empfangenen Signals (Sig) ist.

3. Schaltung nach Anspruch 1 oder 2, dadurch gekennzeichnet, dass der Zeitfunktionsgeber (ZG) ein Sägezahn- oder ein Dreieckgenerator ist.

4. Schaltung nach Anspruch 1 oder 2, dadurch gekennzeichnet, dass der Zeitfunktionsgeber (ZG) ein von einem Zähltaktgenerator (OZ) gesteuerter Zähler ist, und dass der Zähltaktgenerator eine wesentlich höhere Taktfrequenz (fz) als der Bittakt (fb) des empfangenen Signals aufweist.

5. Schaltung nach Anspruch 4, dadurch gekennzeichnet, dass der Zähler ein Auf-Ab-Zähler ist.

6. Schaltung nach einem der vorhergehenden Ansprüche, dadurch gekennzeichnet, dass das empfangene Signal hinter einem Basisbandbegrenzer (BR) dem Eingang der Differenzierschaltung (DS, DS') zugeführt ist.

7. Schaltung nach einem der vorhergehenden Ansprüche, dadurch gekennzeichnet, dass die Differenzierschaltung an ihrem Ausgang zur Zeichenwechselimpulse abgibt, die von Signalimpulsflanken gleicher Polarität abgeleitet sind.

8. Schaltung nach einem der Ansprüche 1 bis 6, dadurch gekennzeichnet, dass die Differenzierschaltung (DS') zwei Ausgänge, nämlich einen Ausgang (a1) für die differenzierten aufsteigenden und einen Ausgang (a2) für die differenzierten absteigenden Flanken der Signalbitfolge aufweist, und dass zwei gleiche Zeitfunktionsgeber (ZG1, ZG2) vorgesehen sind, deren Rücksetzeingänge mit den beiden Ausgängen der Differenzierschaltung und deren Zeitfunktionswertausgänge (b1, b2) mit zugehörigen Eingängen der Auswerteschaltung in Verbindung stehen.

9. Schaltung nach einem der vorhergehenden Ansprüche, dadurch gekennzeichnet, dass die Auswerteschaltung (AS) aus einem dem Zeitfunktionsgeber (ZG) bzw. den Zeitfunktionsgebern (ZG1, ZG2) nachgeschalteten Addierer (AD), einem an den Ausgang bzw. die Ausgänge der Differenzierschaltung (DS, DS') angeschalteten Ereigniszähler (EZ) und einem einen Verhältnisbildner (VB) umfassenden Auswerter (AW) besteht, dessen einem Eingang das eine vorgegebene bestimmte Messblocklänge (MBL) anzeigende Zählergebnis (n) des Ereigniszählers und dessen anderem Eingang gleichzeitig die jeweils über eine Messblocklänge im Addierer aufaddierten Zeitfunktionswerte (M) zugeführt sind.

10. Schaltung nach Anspruch 9, dadurch gekennzeichnet, dass der Auswerter (AW) aus einem Mikroprozessor (MIZ) mit zwei eingangsseitigen, vom Mikroprozessor angesteuerten Speichern (SM, Sn) besteht.

11. Schaltung nach Anspruch 9, dadurch gekennzeichnet, dass die Auswerteschaltung (AS) weiterhin einen von den an einem (a1) der beiden Ausgänge der Differenzierschaltung (DS') auftretenden Zeichenwechselimpulsen getakteten Komparator (KOM), einen dem Komparator nachgeschalteten, im Rhythmus einer Messblocklänge (MBL) rückgesetzten Integrator (I) und einen zusätzlichen Verhältnisbildner (VB') aufweist, dessen einer Eingang mit dem Integratorausgang in Verbindung steht und dessen anderem Eingang im Rhythmus einer Messblocklänge das halbe Zählergebnis (n/2) des Ereigniszählers (EZ) zugeführt ist, dass ferner jeder der beiden Eingänge
des Komparators mit einem zusätzlichen Zeitfunktionsausgang (c1, c2) der beiden Zeitfunktionsgeber (ZG1, ZG2) in Verbindung steht und dass der
Ausgang des zusätzlichen Verhältnisbildners
(VB') einen zweiten Ausgang (ma') der Auswerteschaltung (AS) für ein Stromflusswinkelsignal bildet.

12. Schaltung nach Anspruch 8, dadurch gekennzeichnet, dass die Auswerteschaltung (AS)
aus einem Mikroprozessor (MIZ) mit vier eingangsseitigen, vom Mikroprozessor angesteuerten Speichern (S11, S12, S21, S22) besteht und
dass hierbei zwei Speicher mit ihren Eingängen
mit den Zeitfunktionswertausgängen (b1, b2) der
beiden Zeitfunktionsgeber (ZG1, ZG2) und zwei
Speicher mit ihren Eingängen mit den Ausgängen
(a1, a2) der Differenzierschaltung (DS') in Verbindung stehen.

13. Verwendung der Schaltung nach einem der
Ansprüche 1 bis 9, in der Synchronisiereinrichtung für den Zeittaktgeber (TO, PS) eines Funkempfängers, bei der das Regelsignal für den in
seiner Phase und/oder Frequenz steuerbaren
Zeit-Taktgeber (TO, PS) über einen Phasenvergleich der Taktoszillatorschwingung mit dem ankommenden Signal (Sig) in einem Phasenvergleicher (PV) gewonnen ist, wobei im Verbindungsweg zwischen dem Ausgang des Phasenvergleichers (PV) und dem Stelleingang (x) des Zeittaktgebers (TO, PS) ein steuerbarer Schalter (SS) vorgesehen ist, der vom Ausgangssignal des Auswerters (AW) der Auswerteschaltung (AS) über
eine Schwellwertschaltung (SW) angesteuert wird
und immer dann und so lange die Regelsignalzufuhr unterbricht, wie dieses Ausgangssignal einen unzulässig hohen Phasenjitter anzeigt.

14. Verwendung der Schaltung nach einem der
Ansprüche 1 bis 12 auf einer Endstelle einer Nachrichtenübertragungsstrecke für Analogsignale zur
Überprüfung der Qualität der Nachrichtenstrecke,
wobei sendeseitig in den Analogsignalfluss in
Zeitabständen von der Grössenordnung sec digitale Kennungsblöcke von der Dauer weniger msec
eingeblendet sind, die zeitsynchron auf der Empfangsseite wiederum ausgeblendet und dem Eingang der Schaltung (JME) zur Messung des Phasenjitters zugeführt sind und dass die Lücken im
empfangsseitigen Analogsignalfluss anschliessend durch ein analoges Echosignal, das mittels
eines Schieberegisters (SR) gewonnen ist,
wiederum ausgefüllt werden.

**Claims**

1. Circuit for determining the phase jitter of an
incoming signal, at least certain components of
which possess digital form, at the receiving end of
a signal transmission link, with a differentiating
circuit (DS, DS') which converts the flanks of the
digital signal or signal components into case shift
pulses, with at least on time function generator
(ZG, ZG1, ZG2) which generates a periodic time function, and with an analysis circuit (AS) which is
supplied with the instantaneous time function values of the time function generator which are
produced on the occurrence of the case shift
pulses, characterised in that the freerunning time
function generator (ZG, ZG1, ZG2) is reset by the
case shift pulses into a predetermined starting
position, and that the analysis circuit (AS) contains
a device (AD, EW, AW: AD, EZ, VB: SM Sn, MIZ;
$S_{11}$, $S_{12}$, $S_{21}$, $S_{22}$, Miz) which serves to form the
mean value of the instantaneous time function
values which are received in a given measurement time interval.

2. Circuit as claimed in claim 1, characterised
in that the period duration of the time function
generator (ZG) is equal to the likely bit period of
the received signal (Sig).

3. Circuit as claimed in claim1 or 2, characterised in that the time function generator (ZG) is
a saw-tooth generator or triangular generator.

4. Circuit as claimed in claim 1 or 2, characterised in that the time function generator (ZG) is
a counter controlled by a counting pulse generator
(OZ), and that the counting pulse generator possesses a considerably higher pulse frequency (fz)
than the bit pulse train (fb) of the received signal.

5. Circuit as claimed in claim 4, characterised
in that the counter is an up-down counter.

6. Circuit as claimed in one of the preceding
claims, characterised in that following a base
band limiter (BR) the received signal is fed to the
differentiating circuit (DS, DS').

7. Circuit as claimed in one of the preceding
claims, characterised in that at its output the differentiating circuit emits only case shift pulses
which are derived from signal pulse flanks of the
same polarity.

8. Circuit as claimed in one of the claims 1 to 6,
characterised in that the differentiating circuit
(DS') has two outputs, namely one output (al) for
the differentiated rising flanks of the signal bit
sequence, and one output (a2) for the differentiated falling flanks of the signal bit sequence, and
that two identical time function generators (ZG1,
ZG2) are provided whose reset inputs are connected to the two outputs of the differentiating circuit
and whose time function value outputs (b1, b2) are
connected to associated inputs of the analysis
circuit.

9. Circuit as claimed in one of the preceding
claims, characterised in that the analysis circuit
(AS) consists of an adder (AD) which is connected
following the time function generator (ZG) or time
function generators (ZG1, ZG2), of an event counter (EZ) which is connected to the output or outputs
of the differentiating circuit (DS, DS'), and of an
analyser (AW) which comprises a ration former
(VB) and whose first input is supplied with the
counting result (n) of the event counter which indicates a predetermined specified measurement
block length (MBL), and whose other input is simultaneously supplied with the time function values (M) each of which are added in the adder over
the length of one measurement block.

10. Circuit as claimed in claim 9, characterised in that the analyser (AW) consists of a microprocessor (MIZ) comprising two stores (SM, Sn) which are driven at their inputs by the microprocessor.

11. Circuit as claimed in claim 9, characterised in that the analysis circuit (AS) further comprises a comparator (KOM) which is pulsed by the case shift pulses which occur at one (al) of the two outputs of the differentiating circuit (DS'), an integrator (I) which is connected following the comparator and which is reset in the rhythm of a measurement block length (MBL), and an additional ratio former (VB') whose first input is connected to the integrator output and whose other input is supplied with half the counting result (n'2) of the event counter (EZ) in the rhythm of a measurement block length, that moreover each of the two inputs of the comparator is connected to an additional time function output (c1, c2) of the two time function generators (ZG1, ZG2) and that the output of the additional ratio former (VB') forms a second output (ma') of the analysis circuit (AS) for a current flow angle signal.

12. Circuit as claimed in claim 8, characterised in that the analysis circuit (AS) consists of a microprocessor (MIZ) which has four input-end stores (S11, S12, S21, S22) which are operated by the microprocessor, and that two stores are connected by their inputs to the time function value outputs (b1, b2) of the two time function generators (ZG1, ZG2) and two stores are connected by their inputs to the outputs (a1, a2) of the differentiating circuit (DS').

13. Use of the circuit as claimed in one of the claims 1 to 9, in the synchronising device for the time pulse generator (TO, PS) of a radio receiver, wherein the regulating signal for the time pulse generator (TO, PS) which can be controlled in its phase and/or frequency is obtained in a phase comparator (PV) via a phase comparison of the pulse oscillator oscillation with the incoming signal (Sig), where a controllable switch (SS) is arranged in the connection path between the output of the phase comparator (PV) and the control input (x) of the time pulse generator (TO, PS), which switch is operated by the output signal of the analyser (AW) of the analysis circuit (AS) via a threshold value circuit (SW) and interrupts the regulating signal supply whenever and for such time as this output signal displays an impermissibly high phase jitter.

14. Use of the circuit as claimed in one of the claims 1 to 12 at an end station of a communications transmission link for analogue signals, for checking the quality of the communications link, where at the transmitting end digital code blocks whose duration is a few msec are gated into the analogue signal flow at time intervals in the order of seconds, said code blocks are gated out again in time synchronism at the receiving end and are fed to the input of the circuit (JME) which serves to measure the phase jitter, and that the gaps in the receiving-end analogue signal flow are subsequently filled by an analogue echo signal which has been obtained by means of a shift register (SR).

**Revendications**

1. Circuit pour déterminer l'instabilité de phase d'un signal arrivant, comportant au moins des composantes sous forme numérique, sur le côté réception d'une voie de transmission de signaux, comportant un circuit différenciateur (DS, DS') transformant les flancs des signaux ou des composantes de signaux numériques en des impulsions de changement de signe, au moins un générateur de fonction temporelle (ZG, ZG1, ZG2) produisant une fonction remporelle périodique, et un circuit d'évaluation (AS), auquel sont envoyées les valeurs instantanées du générateur de fonction temporelle, qui sont présentes lors de l'apparition des impulsions de changement de signe, caractérisé en ce que le générateur de fonction temporelle (ZG, ZG1, ZG2), réalisé de manière à fonctionner librement, est ramené respectivement par les impulsions de changement de signe dans une position initiale prédéterminée et que le circuit d'exploitation (AS) contient un dispositif (AD, EW, AW; AD, EZ, VB; SM, Sn, MIZ; $S_{11}$, $S_{12}$, $S_{21}$, $S_{22}$, Miz) servant à former la valeur moyenne des valeurs instantanées de la fonction temporelle reçues pendant un intervalle de temps de mesure prédéterminé.

2. Circuit selon la revendication 1, caractérisé en ce que la durée de la période du générateur de fonction temporelle (ZG) est égale à la période, des bits du signal reçus (Sig), à laquelle on peut s'attendre.

3. Circuit selon la revendication 1 ou 2, caractérisé en ce que le générateur de fonction temporelle (ZG) est un générateur de signaux en dents de scie ou de signaux triangulaires.

4. Circuit selon la revendication 1 ou 2, caractérisé en ce que le générateur de fonction temporelle (ZG) est un compteur commandé par un générateur de cadence de comptage (OZ) et que le générateur de cadence de comptage possède une fréquence de cadence (fz) nettement supérieure à la cadence binaire (fb) du signal reçu.

5. Circuit selon la revendication 4, caractérisé en ce que le compteur est un compteur progressif-dégressif.

6. Circuit selon l'une des revendications précédentes, caractérisé en ce que le signal reçu est envoyé en aval d'un limiteur de bande de base (BR) à l'entrée du circuit différentiateur (DS, DS').

7. Circuit selon l'une des revendications précédentes, caractérisé en ce que le circuit différenciateur délivre à sa sortie uniquement des impulsions de changement de signe, qui sont dérivées des flancs d'impulsions de signal de même polarité.

8, Circuit selon l'une des revendications 1 à 6, caractérisé en ce que le circuit différenciateur (DS') comporte deux sorties, à savoir une sortie (al) pour les flancs montants différenciés et une sortie (a2) pour les flancs descendants différenciés de la suite des bits du signal, et qu'il est prévu deux générateurs identiques de fonctions temporelles (ZG1, ZG2), dont les entrées de remise à l'état initial sont reliées aux deux sorties du circuit différenciateur et dont les sorties (b1, b2) des valeurs des fonctions temporelles sont reliées aux entrées associées du circuit d'évaluation.

9. Circuit selon l'une des revendications précédentes, caractérisé en ce que le circuit d'évaluation (AS) est constitué par un additionneur (AD) branché en série et en aval du générateur de fonction temporelle (ZG) ou des générateurs de fonctions temporelles (ZG1, ZG2), par un compteur d'événements (EZ) raccordé à la sortie ou aux sorties du circuit différenciateur (DS, DS'), et par un organe d'évaluation (AW) comportant un dispositif formateur de quotient (VB) et à une entrée duquel est envoyé le résultat de comptage (n) au compteur d'événements, indiquant une longueur définie prédéterminée de bloc de mesure (MBL) est á l'autre entrée duquel sont envoyées simultanément les valeurs respectives des fonctions temporelles (M) additionnées respectivement pendant une longueur de bloc de mesure dans l'additionneur.

10. Circuit selon la revendication 9, caractérisé en ce que l'organe d'évaluation (AW) est constitué par un microprocesseur (MIZ) comportant deux mémoires (SM, Sn) situées du côté entrée et commandées par le microprocesseur.

11. Circuit selon la revendication 9, caractérisé en ce que le circuit d'évaluation (AS) comporte en outre un comparateur (KOM) commandé de façon cadencée par les impulsions de changement de signe apparaissant à l'une (al) des deux sorties du circuit différenciateur (DS'), un intégrateur (I) branché en série et en aval du comparateur et ramené à l'état initial au rythme d'une longueur de bloc de mesure (MBL), et un dispositif formateur de quotient (VB') supplémentaire, dont une entrée est reliée à la sortie de l'intégrateur et à l'autre entrée duquel la moitié du résultat de comptage (n/2) du compteur d'événements (EZ) est envoyé au rythme d'une longueur de bloc de mesure, qu'en outre chacune des deux entrées du comparateur est reliée à une sortie supplémentaire de fonction temporelle (c1, c2) des deux générateurs de fonctions temporelles (ZG1, ZG2) et que la sortie du dispositif formateur de quotient (VB') supplémentaire forme une seconde sortie (ma') du circuit d'exploitation (AS) pour un signal d'angle de flux de courant.

12. Circuit selon la revendication 8, caractérisé en ce que le circuit d'exploitation (AS) est constitué par un microprocesseur (MIZ) comportant quatre mémoires (S11, S12, S21, S22) situées du côté entrée et commandées par le microprocesseur et que deux mémoires sont reliées par leurs entrées aux sorties des valeurs de fonctions temporelles (b1, b2) des deux générateurs de fonctions temporelles (ZG1, ZG2) et que deux mémoires sont reliées par leurs entrées aux sorties (a1, a2) du circuit différentiateur (DS').

13. Utilisation du circuit selon l'une des revendications 1 à 9, dans le dispositif de synchronisation pour le générateur de cadence temporelle (TO, PS) d'un récepteur radio, dans lequel le signal de régulation pour le générateur de cadence temporelle (TO, PS), qui peut être commandé du point de vue de sa phase et/ou de sa fréquence, est obtenu par l'intermédiaire d'une comparaison de phase de l'oscillation de l'oscillateur de cadence au signal arrivant (Sig) dans un comparateur de phase (PV), un commutateur (SS) pouvant être commandé, qui est piloté par le signal de sortie de l'organe d'évaluation (AW) du circuit d'évaluation (AS) par l'intermédiaire d'un circuit à valeur de seuil (SW) et interrompant toujours l'envoi du signal de régulation tant que ce signal de sortie indique une instabilité de phase d'une valeur élevée inadmissible, étant prévue dans la voie de jonction entre la sortie du comparateur de phase (PV) et l'entrée de positionnement (x) du générateur de cadence temporelle (TO, PS).

14. Utilisation du circuit selon l'une des revendications 1 à 12 dans un poste terminal d'une voie de transmission d'informations pour des signaux analogiques, en vue du contrôle de la qualité de cette voie, dans laquelle du côté émission, dans le flux du signal analogique, se trouvent injectés, à des intervalles de temps de l'ordre de la seconde, des blocs d'indicatifs numériques d'une durée de quelques millisecondes qui sont à nouveau extraits de façon synchrone dans le temps du côté réception et sont envoyés à l'entrée du circuit (JME) servant à la mesure de l'instabilité de phase, et dans laquelle les espaces vides dans le flux du signal analogique du côté réception sont à nouveau remplis ultérieurement par un signal d'écho analogique, qui est obtenu au moyen d'un registre à décalage (SR).

FIG 1

FIG 2

# FIG 3

FIG 4

0 011 699

FIG 5

19

# FIG 6

FIG 7

FIG 8

# FIG 9